# EUROPEAN PATENT APPLICATION

(11) **EP 1 164 052 A2**
(43) Date of publication of application: **19.12.2001**
(21) Application number: 01304509.1
(22) Date of filing: 23.05.2001
(51) Int. Cl.: B60Q 1/06, H01R 12/36, F21V 21/14

(54) **Connection structure for connecting an electrical part to a printed circuit board**

(30) Priority: 13.06.2000 JP 2000182322
(71) Applicant: ALPS ELECTRIC CO., LTD., Ota-ku Tokyo 145 (JP)
(72) Inventor: Suda, Sumiko, c/o Alps Electric Co., Ltd., Tokyo 145 (JP)
(74) Representative: Kensett, John Hinton

(57) **Abstract**

The present invention provides a connection structure for connection of an electrical part to a printed circuit board that allows soldering-free electrical connection between the electrical part and the printed circuit board and provides an excellent contact between the two. In the present invention's connection structure for connecting an electrical part (D) to a printed circuit board (7), pullout conductors (B) have at least a part thereof made of a spring metallic material and contact parts (6a) made of a spring metallic material, wherein the contact parts are supported at each end (6d) by a support part (5c) and resiliently contact a conductive pattern of a printed circuit board in a middle part (6e) thereof. With this construction, soldering for connecting an electrical part and the printed circuit board is unnecessary, lightening workload on a set manufacturer and making it possible to provide a connection structure for connecting electrical parts to a printed circuit board so as to increase productivity.

## Description

### BACKGROUND OF THE INVENTION

### 1. Field of the Invention

The present invention relates to a connection structure for connecting electrical parts suitably used with a headlight level sensor and the like of an automobile to a printed circuit board.

### 2. Description of the Prior Art

Conventional electrical parts used with a headlight level sensor of an automobile are connected to a printed circuit board in such a way that the terminals of the electrical parts comprising a slide type variable resistor are soldered directly to a conductive pattern of the printed circuit board.

Specifically, an electrical part produced by a part manufacturer is supplied to a set maker or an auto headlight unit manufacturer, and the set maker mounts the electrical part by snap fastening on a circuit board (printed circuit board) on which various circuit parts are soldered by reflow, solders the terminals of the electrical part to a conductive pattern of the printed circuit board, and snap-fastens a case storing an actuator for changing an angle of a headlight and the like to the printed circuit board. Thus, the headlight unit is manufactured.

Since a conventional electrical part is large in shape and constructed so that terminals thereof penetrate holes of a printed circuit board, soldering by reflow is difficult. For this reason, in one process, circuit parts are soldered by reflow to one conductive pattern of the printed circuit board provided with conductive patterns at both sides, while, in a different process, the electrical part must be soldered to another conductive pattern.

Also, the printed circuit board requires incorporation of two processes: snap-fastening of the electrical part and snap-fastening of a case.

A conventional connection structure for connection of an electrical part to a printed circuit board requires soldering of the electrical part to the printed circuit board and therefore has been problematic in terms of inconvenience and poor productivity.

### SUMMARY OF THE INVENTION

Therefore, the present invention provides a connection structure for connection of an electrical part to a printed circuit board that allows soldering-free electrical connection between the electrical part and the printed circuit board and provides an excellent contact between the two.

To solve the above problem, as a first solution means, there is provided a connection structure for connecting an electrical part to a printed circuit board that comprises: an electrical part having an operation part and pullout conductors, operated by the operation part; and a printed circuit board having a conductive pattern to which the pullout conductors are electrically connected, wherein the pullout conductors have at least a part thereof made of a spring metallic material and contact parts made of a spring metallic material, wherein the contact parts are supported at each end by a support part and resiliently contact the conductive pattern in the middle part thereof.

Preferably, the contact parts are secured at one end and has the other end as a free end, and the other end as a free end is slidable on the support part.

Preferably, a plurality of the pullout conductors are juxtaposed, and the support part is provided with partition walls at other ends as free ends of the contact parts to partition the other ends between the contact parts by the partition walls.

Preferably, the electrical part comprises a body part and a holder made of a synthetic resin; the pullout conductors comprise terminals and outside connection parts having the contact parts, electrically connected to the terminals and made of a spring metallic material; the body part has the operation part, a cabinet holding the operation part, and the terminals; the holder has the outside connection parts and the support part supporting the contact parts; the body part and the holder are combined to form the electrical part; and the terminals and the outside connection parts are electrically connected.

Preferably, when the holder is installed in the body part, the terminals and the outside connection parts match.

Preferably, the holder or cabinet is provided with snap legs, and the body part and the holder are combined with each other by the snap legs.

Preferably, the cabinet or holder is provided with a pair of legs placed at least at an interval, and the legs abut the surface of the printed circuit board to position the printed circuit board.

Preferably, the support part is provided between a pair of the legs and placed in opposed relation to the printed circuit board, and the contact parts are disposed between the support part and the printed circuit board.

Preferably, the holder has a bottom wall, and the support part coupled to the bottom wall and provided in an upright position with respect to the bottom wall; with the operation part facing upward, the body part is disposed on the bottom wall; the terminals at a lower portion of the body part are electrically connected to the outside connection parts; and the printed circuit board disposed in parallel to the axial direction of the operation part is made to abut against the pair of legs that extend in the horizontal direction, which is a direction square to the axial direction of the operation part.

Preferably, the cabinet is in the shape of a rectangular box, and a guide is formed by the cabinet and the support part to combine the body part and the holder.

Preferably, the body part is constructed in linear operation type in which the operation part performs slide operation.

Preferably, the body part comprises a slide type variable resistor.

An embodiment of the invention will now be described, by way of example, with reference to the accompanying diagrammatic drawings, in which:
FIG. 1 is a plan view of the present invention's connection structure for connecting an electrical part to a printed circuit board;
FIG. 2 is a front view of the present invention's connection structure for connecting an electrical part to a printed circuit board;
FIG. 3 is a partially cutaway front view of the present invention's connection structure for connecting an electrical part to a printed circuit board;
FIG. 4 is a sectional view of main portions of the connection structure taken along a line 4-4 of FIG. 1;
FIG. 5 is a right side view of the present invention's connection structure for connecting an electrical part to a printed circuit board;
FIG. 6 is a sectional view of main portions of the connection structure taken along a line 6-6 of FIG. 4; and
FIG. 7 relates to the present invention's connection structure for connecting an electrical part to a printed circuit board, and illustrates a connection state between the electrical part and the printed circuit board.

### DESCRIPTION OF THE PREFERRED EMBODIMENTS

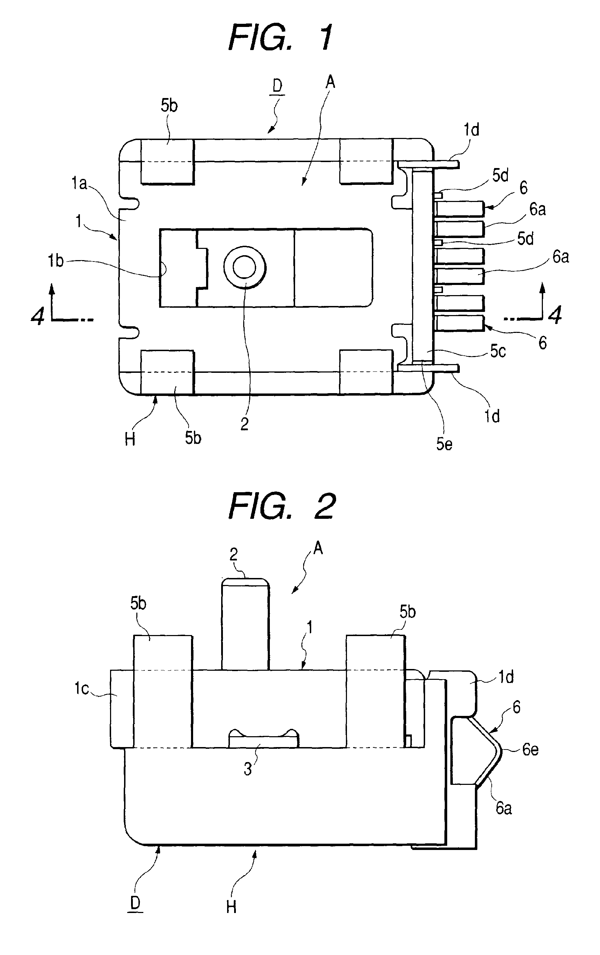

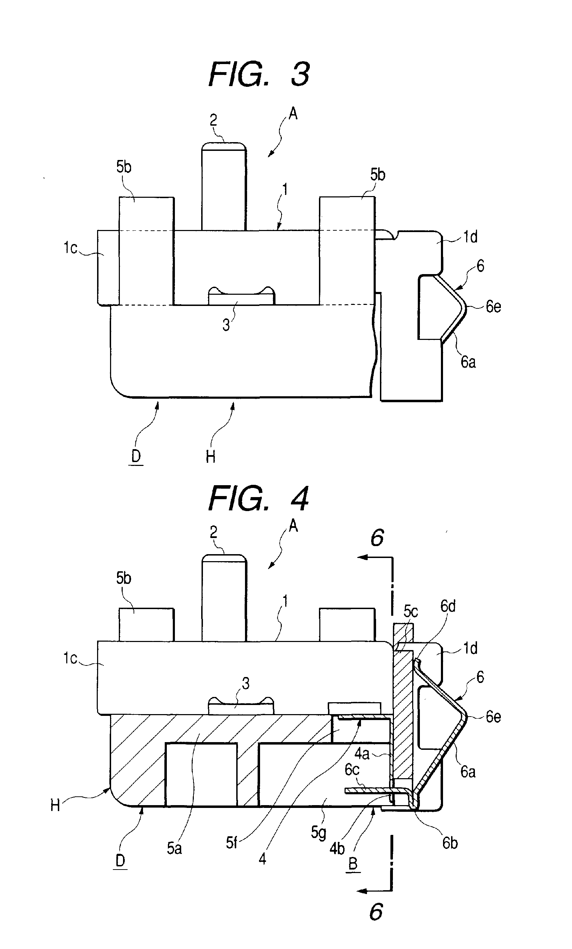

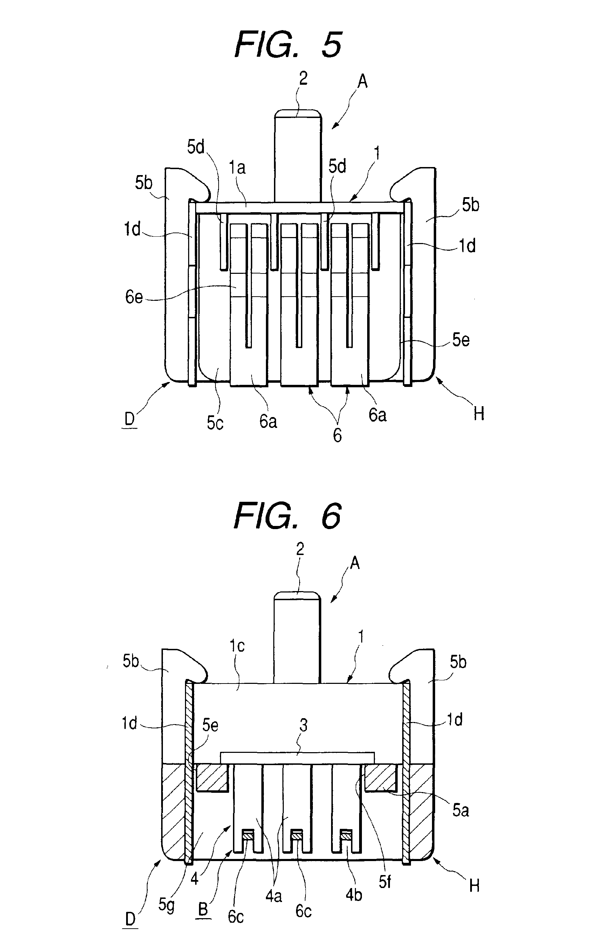

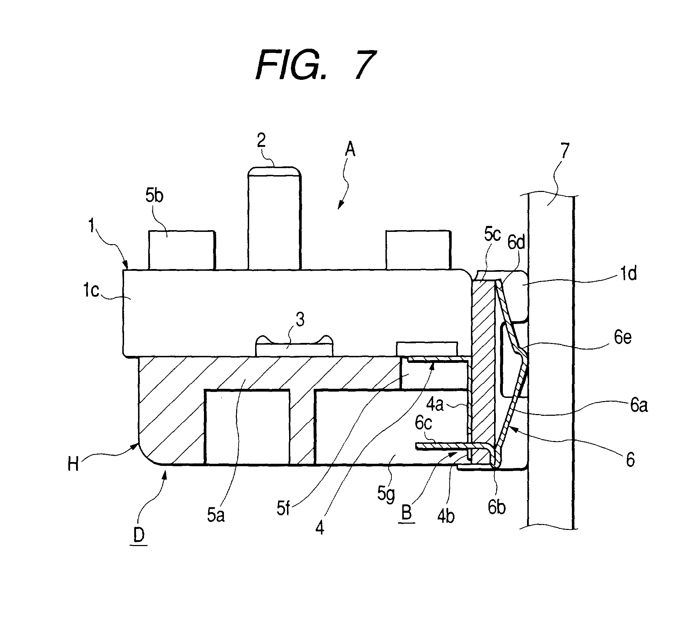

Drawings of a connection structure for connecting an electrical part to a printed circuit board of the present invention are described. FIG. 1 is a plan view of the present invention's connection structure for connecting an electrical part to a printed circuit board; FIG. 2 is a front view of the present invention's connection structure for connecting an electrical part to a printed circuit board; FIG. 3 is a partially cutaway front view of the present invention's connection structure for connecting an electrical part to a printed circuit board; FIG. 4 is a sectional view of main portions of the connection structure taken along a line 4-4 of FIG. 1; FIG. 5 is a right side view of the present invention's connection structure for connecting an electrical part to a printed circuit board; FIG. 6 is a sectional view of main portions of the connection structure taken along a line 6-6 of FIG. 4; and FIG. 7 relates to the present invention's connection structure for connecting an electrical part to a printed circuit board, and illustrates a connection state between the electrical part and the printed circuit board.

Next, the present invention's connection structure for connecting an electrical part to a printed circuit board is described based on FIGS. 1 to 7. An electrical part D comprises a body part A including a slide type variable resistor of linear operation type, and the like, and a holder H made of a synthetic resin, combined with the body part A.

The body part A comprises: a rectangular box-shaped cabinet 1 constructed from a metallic plate or the like; an operation part 2 for operating a movable member (not shown) provided within the cabinet 1; an insulating board 3 on which resistors and the like (not shown) are disposed; and plural terminals 4 made of a metallic material and the like, connected to the resistors and secured to the insulating board 3, wherein the body part A changes resistance values by sliding the operation part 2.

The operation part 2 projects outward from a hole 1b provided on an upper wall 1a of the cabinet 1, and slides lengthwise within the hole 1b, the body part A includes a linear operation type variable resistor, and at a side wall 1c of the cabinet 1 are provided a pair of legs 1d that extend in the horizontal direction, which is a direction square to the axial direction of the operation part 2, and are placed at an interval from each other.

Plural terminals 4 are juxtaposed at a lower portion of the body part A, each terminal 4 is bent in the L-character shape and has a bent part 4a upright from the insulating board 3, and a notched concave part 4b is provided at the tip of the bent part 4a.

The holder, which is formed of a molded product of synthetic resin, has: a flat bottom wall 5a; plural snap legs 5b that are upright from a side edge facing the bottom wall 5a and provided in opposed relation to each other; a flat support part 5c coupled with one end of the bottom wall 5a and provided in an upright position with respect to the bottom wall 5a; convex partitions 5d formed at a given interval from each other on an outer surface of the support part 5c; grooves 5e formed between the bottom wall 5a and the partitions 5d; a hole 5f provided adjacent to the partition 5d and on the bottom wall 5a; and a storing part 5g with a lower portion open formed under the hole 5f of the bottom wall 5a and surrounded by walls.

Plural outside connection parts 6, which are made of a spring metallic material, have: contact parts 6a in a V shape; an one end 6b folded and bent; and a terminal part 6c extending from the end 6b.

The outside connection parts 6 are juxtaposed and secured with one end 6b buried in the support part 5c. When the outside connection parts 6 are secured, the terminal parts 6c are in the storing part 5g of the holder H; another end 6d as a free end of the contact parts 6a abuts slidably on the outer surface of the support part 5c; and a middle part 6e between the one end 6b and another end 6d is away from the outer surface of the support part 5d.

When plural outside connection parts 6 are provided in the holder H, the partition 5d is placed between adjacent other ends 6d to partition the adjacent other ends 6d.

A method of combining the body part A and the holder H thus configured is described. With the operation part 2 facing upward, from the insulating board 3 placed at a lower portion of the body part A, the body part A is engaged in the holder H.

During the engagement, the side wall 1c of the cabinet 1 abuts on the inner surface of the support part 5c, the cabinet 1 and the support part 5c constitute engagement guide, and a pair of legs 1d fit in the groove 5e.

When the body part A has been mounted on the bottom wall 5a, the widened snap legs 5b are restored, the body part A is anchored by anchoring parts provided in the snap legs 5b, and the body part A and the holder H are combined and coupled with each other.

When the body part A and the holder H have been combined, as shown in FIG. 6, the terminal 4 penetrates the hole 5f, the terminal parts 6c are positioned within the concave parts 4b, the terminal 4 and the outside connection parts 6 are matched, and a pullout conductor B is constituted of the terminal 4 and the outside connection parts 6.

When the body part A and the holder H have been combined, as shown in FIG. 1, between a pair of legs 1d, the support part 5c is positioned and plural contact parts 6a are positioned.

Although, in this embodiment example, the holder H is provided with the snap legs 5b, the snap legs may also be provided in the cabinet 1 so that the body part A and the holder H are combined by the snap legs.

After the holder H is installed in the body part A, the terminal 4 and the terminal part 6c of the outside connection parts 6 are soldered and electrically connected to form the pullout conductor B.

The electrical part D thus configured is stored and maintained in a box-shaped case (not shown) storing an actuator for changing an angle of a head light in a head light unit of an automobile and the like, together with the actuator and the like, and the case is snap-fastened to the printed circuit board 7, which is a circuit board on which various circuit parts are soldered by reflow.

When the case has been installed, as shown in FIG. 7, a pair of legs 1d abut against the printed circuit board 7 on which circuit parts are disposed, the positions of the printed circuit board 7 and the electrical part D are determined by the legs 1d.

At this time, the printed circuit board 7 is placed in parallel relation to the axial direction of the operation part 2.

When the electrical part D and the printed circuit board 7 have been combined in this way, the middle part 6e of the contact parts 6a between the printed circuit board 7 and the support part 5c is pressed by the printed circuit board 7 while holding contact with the conductive pattern, with the result that the contact parts 6a are supported at one end 6b thereof and the other end 6d by the support part 5c, and the middle part 6e is strongly pressed against the conductive pattern, bringing both into an excellent contact.

Thus, the contact between the middle part 6e and the conductive pattern is not impaired regardless of inclination or other slight displacements of the electrical part D caused by movement of the operation axis 2.

When the contact parts 6a are pressed by the printed circuit board 7, the other end 6d as a free end slides on the support part 5c to reduce distortion of the contact parts 6a, and the other end 6d is prevented during sliding by the partition 5d from hitting an adjacent other end 6d to ensure the sliding operation.

When the electrical part D and the printed circuit board 7 have been combined, the support part 5c is placed in opposed relation to the printed circuit board 7, and a contact pressure of the contact parts 6a to the conductive pattern can be decided by abutting the printed circuit board 7 against the legs 1d.

As in this embodiment example, where the outside connection parts 6 placed between the printed circuit board 7 and the electrical part D are placed within the range of one side of the electrical part D, the mounting area of the printed circuit board 7 can be made smaller in comparison with the case where a part of the outside connection parts 6 projects out of one side of the electrical part D.

Although, in this embodiment example, the legs 1d abutting the printed circuit board 7 are provided in the cabinet 1, the legs may also be provided in the holder H.

Although, in this embodiment, the electrical part D comprises the body part A and the holder H, the electrical part D may also include only the body part A. Although, in this embodiment, the pullout conductor B comprises the terminal 4 and the outside connection parts 6, the pullout conductor B may also comprise a part made of a spring metallic material.

The body part A may also be rotation operation type as well as linear operation type, and the printed circuit board 7 may also be placed at a lower portion of the body part A.

To apply resilience to the outside connection parts 6 at all times, in this embodiment example, the case storing the electrical part D is snap- fastened to the printed circuit board. However, the legs 1d or holder H may be provided with snap legs for snap-fastening to the printed circuit board.

In the present invention's connection structure for connecting the electrical part to the printed circuit board, the pullout conductor B has at least a part thereof made of a spring metallic material and includes the contact parts 6a made of a spring metallic material, and with the contact part 6a supported at each end thereof by the support part 5c, the middle part 6e resiliently contacts the conductive pattern of the printed circuit board 7. With this construction, soldering for connecting the electrical part D and the printed circuit board 7 is unnecessary, lightening workload on a set manufacturer and making it possible to provide a connection structure for connecting electrical parts to a printed circuit board so as to increase productivity.

Since the contact parts 6a are supported at each end thereof to ensure contact with the conductive pattern, the contact between the middle part 6e and the conductive pattern is not impaired regardless of inclination or other slight displacements of the electrical part D possibly caused by movement of the operation axis 2.

Also, by bringing the contact parts 6a into contact with the conductive pattern, the inexpensive printed circuit board 7 with the conductive pattern formed on one side thereof can be used.

With the contact parts 6a supported at each end thereof by the support part 5c, the middle part 6e resiliently contacts the conductive pattern of the printed circuit board 7. Therefore, the contact parts 6a are supported at one end 6b thereof and the other end 6d by the support part 5c, and the middle part 6e is strongly pressed against the conductive pattern, bringing both into an excellent contact.

The contact parts 6a are secured at one end 6b thereof and has the other end 6d as a free end, and the other end 6d as a free end is slidable on the support part 5c. With this construction, the contact parts 6a can become free upon pressure from the printed circuit board 7, reducing distortion of the contact parts 6a.

Plural pullout conductors B are juxtaposed, the support part 5c is provided with the partition 5d at the other end 6d (free end) of the contact parts 6a, and the other end 6d between adjacent contact parts 6a is partitioned by the partition 5d. With this construction, the other end 6d is prevented during sliding by the partition 5d from hitting an adjacent other end 6d to ensure the sliding operation.

The electrical part comprises the body part A and the holder H made of a synthetic resin; the pullout conductor B comprises the terminal 4 and the outside connection parts 6 having the contact parts 6a, electrically connected to the terminals 4 and made of a spring metallic material; the body part A has the operation part 2, the cabinet 1 holding the operation part 2, and the terminal 4; the holder H has the outside connection parts 6 and the support part 5c supporting the contact parts 6a; the body part A and the holder H are combined to form the electrical part D; and the terminals 4 and the outside connection parts 6 are electrically connected. With this construction, by combining the body part A and the holder H, the printed circuit board 7 can be easily connected to the electrical part D vertically, horizontally, or in other directions.

By combining the body part A and the holder H, a connection structure for connecting electrical parts to a printed circuit board can be provided to meet different types of connections by sharing the body part A and only changing various holders provided in advance.

When the holder H is installed in the body part A, the terminals 4 and the outside connection parts 6 match. By this arrangement, at the same time when both have been combined, the terminals 4 and the outside connection parts 6 are brought close, easing subsequent soldering.

Since the holder H or cabinet 1 is provided with the snap legs 5b, and the body part A and the holder H are combined with each other by the snap legs 5b, the operation of combining both is eased, increasing productivity.

The cabinet 1 or holder H is provided with a pair of legs 1d placed at least at an interval, and the legs 1d abut the surface of the printed circuit board 7 to position the printed circuit board 7. With this construction, the printed circuit board 7 can be correctly positioned for the electrical part D.

The support part 5c is provided between a pair of legs 1d and placed in opposed relation to the printed circuit board 7, and the contact parts 6a are disposed between the support part 5c and the printed circuit board 7. With this construction, when the printed circuit board 7 abuts the legs 1d, a contact pressure of the contact parts 6a to the conductive pattern can be decided and a desired contact pressure can be obtained by changing the length of the legs 1d.

The holder H has the bottom wall 5a, and the support part 5c coupled to the bottom wall 5a and provided in an upright position with respect to the bottom wall 5a; with the operation part 2 facing upward, the body part A is disposed on the bottom wall 5a; the terminals 4 at a lower portion of the body part A are electrically connected to the outside connection parts 6; and the printed circuit board 7 disposed in parallel to the axial direction of the operation part 2 is made to abut against a pair of legs 1d that extend in the horizontal direction, which is a direction square to the axial direction of the operation part 2. With this construction, a connection structure is easily obtained for connection with the printed circuit board 7 disposed in a longitudinal position, which is in a vertical direction to the electrical part D, and, a connection structure can be provided for connecting electrical parts particularly suitably used with a headlight level sensor of an automobile to a printed circuit board.

By providing a connection structure at the side of the electrical part D, the area of the electrical part D (mounting area) facing the surface of the printed circuit board 7 can be reduced, so that the printed circuit board 7 can be miniaturized.

The cabinet 1 is in the shape of a rectangular box, and a guide is formed by the cabinet 1 and the support part 5c to combine the body part A and the holder H. With this construction, both can be correctly and easily combined, increasing workability.

Since the body part A is constructed in linear operation type in which the operation part 2 performs slide operation, a connection structure can be provided for connecting electrical parts particularly suitably used with a headlight level sensor of an automobile to a printed circuit board.

Also, since the body part A comprises a slide type variable resistor, a connection structure can be provided for connecting electrical parts particularly suitably used with a headlight level sensor of an automobile to a printed circuit board.

## Claims

1. A connection structure for connecting an electrical part to a printed circuit board that comprises:
an electrical part having an operation part and pullout conductors, operated by the operation part; and
a printed circuit board having a conductive pattern to which the pullout conductors are electrically connected,
wherein the pullout conductors have at least a part thereof made of a spring metallic material and contact parts made of a spring metallic material, wherein the contact parts are supported at each end by a support part and resiliently contact the conductive pattern in the middle part thereof.

2. A connection structure for connecting an electrical part to a printed circuit board according to claim 1, wherein the contact parts are secured at one end and has the other end as a free end, and the other end as a free end is slidable on the support part.

3. A connection structure for connecting an electrical part to a printed circuit board according to claim 1 or 2, wherein a plurality of the pullout conductors are juxtaposed, and the support part is provided with partition walls at other ends as free ends of the contact parts to partition the other ends between the contact parts by the partition walls.

4. A connection structure for connecting an electrical part to a printed circuit board according to claim 1, 2 or 3, wherein
the electrical part comprises a body part and a holder made of a synthetic resin;
the pullout conductors comprise terminals and outside connection parts having the contact parts, electrically connected to the terminals and made of a spring metallic material;
the body part has the operation part, a cabinet holding the operation part, and the terminals;
the holder has the outside connection parts and the support part supporting the contact parts;
the body part and the holder are combined to form the electrical part; and
the terminals and the outside connection parts are electrically connected.

5. A connection structure for connecting an electrical part to a printed circuit board according to any preceding claim, wherein when the holder is installed in the body part, the terminals and the outside connection parts match.

6. A connection structure for connecting an electrical part to a printed circuit board according to any preceding claim, wherein the holder or cabinet is provided with snap legs, and the body part and the holder are combined with each other by the snap legs.

7. A connection structure for connecting an electrical part to a printed circuit board according to claim 6, wherein the cabinet or holder is provided with a pair of legs placed at least at an interval, and the legs abut the surface of the printed circuit board to position the printed circuit board.

8. A connection structure for connecting an electrical part to a printed circuit board according to claim 7, wherein the support part is provided between a pair of the legs and placed in opposed relation to the printed circuit board, and the contact parts are disposed between the support part and the printed circuit board.

9. A connection structure for connecting an electrical part to a printed circuit board according to claim 7, wherein:
the holder has a bottom wall, and the support part coupled to the bottom wall and provided in an upright position with respect to the bottom wall;
with the operation part facing upward, the body part is disposed on the bottom wall;
the terminals at a lower portion of the body part are electrically connected to the outside connection parts; and
the printed circuit board disposed in parallel to the axial direction of the operation part is made to abut against the pair of legs that extend in the horizontal direction, which is a direction square to the axial direction of the operation part.

10. A connection structure for connecting an electrical part to a printed circuit board according to claim 9, wherein the cabinet is in the shape of a rectangular box, and a guide is formed by the cabinet and the support part to combine the body part and the holder.

11. A connection structure for connecting an electrical part to a printed circuit board according to claim 4, wherein the body part is constructed in linear operation type in which the operation part performs slide operation.

12. A connection structure for connecting an electrical part to a printed circuit board according to claim 11, wherein the body part comprises a slide type variable resistor.
